# EUROPÄISCHE PATENTANMELDUNG

(11) **EP 1 227 061 A2**
(43) Veröffentlichungstag der Anmeldung: **31.07.2002**
(21) Anmeldenummer: 01127971.8
(22) Anmeldetag: 24.11.2001
(51) Int. Cl.: B81B 3/00

(54) **Herstellungsverfahren für ein mikromechanisches Bauelement**

(30) Priorität: 24.01.2001 DE 10102993
(71) Anmelder: ROBERT BOSCH GMBH, 70442 Stuttgart (DE)
(72) Erfinder: Fischer, Frank, 72810 Gomaringen (DE); Bischof, Udo, 72827 Wannweil (DE); Metzger, Lars, 72458 Albstadt (DE)

(57) **Zusammenfassung**

Die Erfindung schafft ein Verfahren zum Herstellen eines mikromechanischen Bauelements mit den Schritten: Bereitstellen eines Substrats (1; 2; 4) mit einer Vorderseite und einer Rückseite; Strukturieren der Vorderseite des Substrats (1; 2; 4); zumindest teilweises Abdecken der strukturierten Vorderseite des Substrats (1; 2; 4) mit einer Germanium-enthaltenden Schutzschicht (7; 7'; 7"); Strukturieren der Rückseite des Substrats (1; 2; 4); und zumindest teilweises Entfernen der Germanium-enthaltenden Schutzschicht (7; 7'; 7") von der strukturierten Vorderseite des Substrats (1; 2; 4).

## Beschreibung

### STAND DER TECHNIK

Die vorliegende Erfindung betrifft ein Herstellungsverfahren für ein mikromechanisches Bauelement.

Obwohl auf beliebige mikromechanische Bauelemente und Strukturen, insbesondere Sensoren und Aktuatoren, anwendbar, werden die vorliegende Erfindung sowie die ihr zugrundeliegende Problematik in bezug auf einen in der Technologie der Silizium-Oberflächenmikromechanik herstellbaren mikromechanischen Drehratensensor oder Beschleunigungssensor mit einer getrenchten mikromechanischen Funktionsschicht erläutert.

Bei solchen mikromechanischen Bauelementen werden sowohl oberflächen- als auch volumenmikromechanische Prozessschritte durchgeführt. Die volumenmikromechanischen Prozesse werden bei der Rückseitenprozessierung angewendet. Dazu wird der Wafer mit seiner bereits strukturierten Vorderseite gedreht und mit dieser auf Handlersysteme bzw. Gerätehalterungen abgelegt.

Dabei kann es zur Verunreinigung der Vorderseite kommen, d.h. Partikel können sich an der strukturierten Oberfläche anlagern. Diese Partikel können sich bei späteren Vorderseitenätzprozessen auf die darunterliegenden Schichten übertragen. Durch die nachfolgenden Prozessschritte können frei bewegliche Partikel entstehen, die die Funktion des betreffenden mikromechanischen Bauelements beeinträchtigen.

Es wurde ein Verfahren vorgeschlagen, bei dem eine temporäre Aluminium-Schutzschicht die Vorderseite während des Rückseitenprozesses schützt. Nach der Rückseitenprozessierung wird diese Schutzschicht naßchemisch entfernt, wobei Partikel auf der Oberfläche unterätzt und abgehoben werden. Dieses Verfahren ist jedoch sehr komplex und aufwendig, da zusätzliche Prozessschritte und Maskenebenen erforderlich sind.

### VORTEILE DER ERFINDUNG

Das erfindungsgemäße Herstellungsverfahren für ein mikromechanisches Bauelement mit den Merkmalen des Anspruchs 1 weist den Vorteil auf, daß die Germanium-Schutzschicht auf der Vorderseite die darunterliegenden strukturierten Schichten während des Rückseitenprozesses gegen Partikel schützt. Die Partikel lagern sich somit an der Schutzschicht an und können gemeinsam mit der Schutzschicht in einem naßchemischen Ätzprozess entfernt werden.

Germanium als Schutzschicht hat den Vorteil, dass es in einem Niedertemperatur(< 450°C)-LPCVD-Verfahren abgeschieden werden kann, wodurch die Kompatibilität zu Aluminium gegeben ist. Die Abscheideraten liegen um die 50 nm/min. Es ist auch möglich Germanium selektiv auf Silizium gegenüber Siliziumdioxid aufzuwachsen. Um Germanium auf Oxid abzuscheiden, wird eine Polysilizium-Nukleationsschicht benötigt. Die Germaniumschicht lässt sich mit den in der Halbleitertechnologie bekannten Trocken- bzw. Plasmaätzverfahren strukturieren. Germanium als Schutzschicht für die Wafervorderseite hat den Vorteil, dass diese nach dem Rückseitenprozess naßchemisch mit einem Wasserstoffperoxid (H₂O₂) enthaltenden Medium entfernt werden kann. Durch den naßchemischen Prozess werden die Partikel auf der Waferoberfläche unterätzt und ebenfalls entfernt. Germanium lässt sich naßchemisch selektiv gegenüber Oxid, Nitrid, Aluminium und Silizium entfernen. Durch diese Selektivitäten und den niedertemperatur Abscheideprozess ist die Kompatibilität zu den standard CMOS-Prozessen gegeben. Da Germanium von standard Reinigungsprozessen (RCA, Piranha) angegriffen wird, müssen alternative Reinigungsverfahren wie 02-Plasma angewendet werden. Es ist jedoch auch möglich die Germaniumschicht mit einem CVD-Oxid abzudecken. Diese Oxidschicht kann zu einem späteren Zeitpunkt mit Flusssäure entfernt werden, wobei das Germanium nicht angegriffen wird. Da Germanium von KOH nicht angegriffen wird, kann es als Ätzmaske beim Rückseitenprozess eingesetzt werden. Dies ermöglicht eine KOH-Ätzung ohne Ätzdose.

In den Unteransprüchen finden sich vorteilhafte Weiterbildungen und Verbesserungen des Gegenstandes der Erfindung.

Gemäß einer bevorzugten Weiterbildung weist das Substrat ein Wafersubstrat, eine darauf vorgesehene erste Opferschicht und eine darauf vorgesehene mikromechanische Funktionsschicht auf, wobei die mikromechanische Funktionsschicht die Vorderseite und das Wafersubstrat die Rückseite bildet.

Gemäß einer weiteren bevorzugten Weiterbildung wird auf der Vorderseite des Substrats eine erste Hartmaske gebildet wird und die Germanium-enthaltende Schutzschicht selektiv in den Öffnungen der Hartmaske gebildet.

Gemäß einer weiteren bevorzugten Weiterbildung wird auf der Rückseite des Substrats die Germanium-enthaltende Schutzschicht ganzflächig gebildet.

Gemäß einer weiteren bevorzugten Weiterbildung wird auf der Vorderseite des Substrats eine erste Hartmaske gebildet und die Germanium-enthaltende Schutzschicht ganzflächig über der Hartmaske gebildet.

Gemäß einer weiteren bevorzugten Weiterbildung wird die Germanium-enthaltende Schutzschicht über einer ganzflächigen Nuleationsschicht gebildet.

Gemäß einer weiteren bevorzugten Weiterbildung wird auf der Rückseite des Substrats eine zweite Hartmaske gebildet und wird damit bei zumindest teilweise durch die Germanium-enthaltende Schutzschicht abgedeckter Vorderseite eine Kaverne in die Rückseite geätzt.

Gemäß einer weiteren bevorzugten Weiterbildung wird nach dem Ätzen der Kaverne die Germanium-enthaltende Schutzschicht von der Vorderseite entfernt wird und werden dann mittels der ersten Hartmaske Gräben in der mikromechanischen Funktionsschicht geätzt.

Gemäß einer weiteren bevorzugten Weiterbildung wird die zweite Hartmaske aus der rückseitigen enthaltenden Schutzschicht gebildet.

### ZEICHNUNGEN

Ausführungsbeispiele der Erfindung sind in der Zeichnung dargestellt und in der nachfolgenden Beschreibung näher erläutert.

Es zeigen:
- Fig. 1-6: eine schematische Querschnittsdarstellung des Herstellungsprozesses für einen Drehratensensor gemäß einer ersten Ausführungsform der vorliegenden Erfindung;
- Fig. 7-11: eine schematische Querschnittsdarstellung des Herstellungsprozesses für einen Drehratensensor gemäß einer zweiten Ausführungsform der vorliegenden Erfindung; und
- Fig. 12-15: eine schematische Querschnittsdarstellung des Herstellungsprozesses für einen Drehratensensor gemäß einer dritten Ausführungsform der vorliegenden Erfindung.

### BESCHREIBUNG DER AUSFÜHRUNGSBEISPIELE

In den Figuren bezeichnen gleiche Bezugszeichen gleiche oder funktionsgleiche Bestandteile.

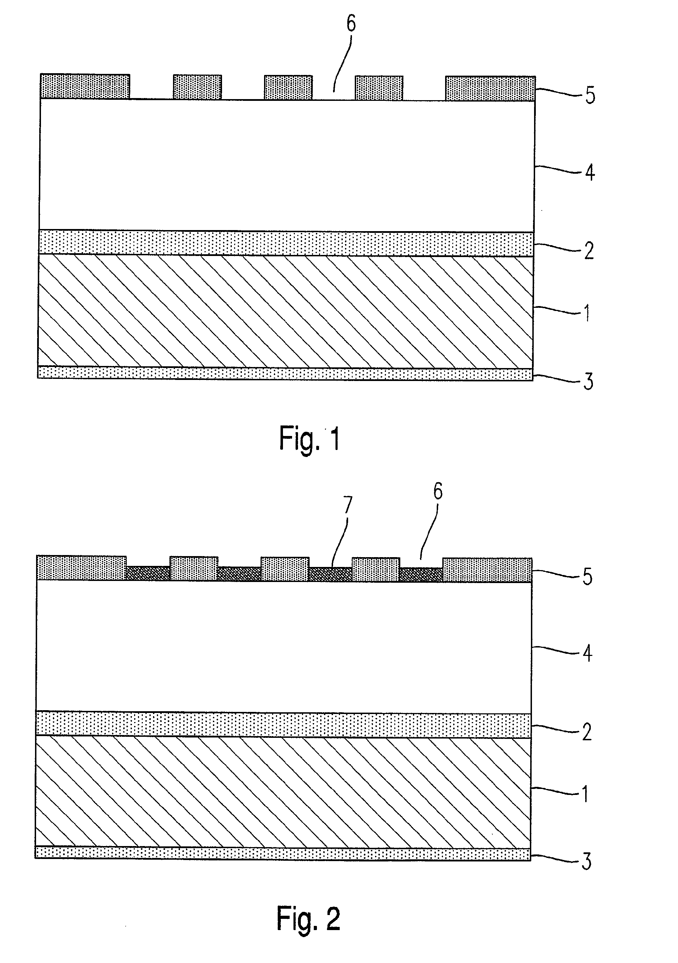

Fig. 1-6 zeigen eine schematische Querschnittsdarstellung des Herstellungsprozesses für einen Drehratensensor gemäß einer ersten Ausführungsform der vorliegenden Erfindung.

Gemäß Fig. 1 wird auf einem Grundsubstrat 1 aus Silizium auf der Vorder- und Rückseite eine erste bzw. zweite Oxidschicht 2, 3 aufgebracht. In einem weiteren Prozessschritt erfolgt dann die Abscheidung einer dicken polykristallinen Siliziumschicht 4 auf der Vorderseite. Auf die polykristalline Siliziumschicht 4 wird eine dritte Oxidschicht 5 abgeschieden. Diese wird über einen fotolithografischen Prozess strukturiert. Die strukturierte dritte Oxidschicht 5 dient bei einem Trench-Prozess, der nach dem Rückseitenprozess durchgeführt wird, als Hartmaske.

Würde man den Wafer nach der Strukturierung der dritten Oxidschicht 5 zur Rückseitenprozessierung umdrehen, so kann die dritte Oxidschicht 5 durch die Auflage auf den Gerätehalterungen verkratzt bzw. beschädigt werden. Die dabei entstehenden Partikel können in die Öffnungen 6 der strukturierten dritten Oxidschicht 5 gelangen und haften bleiben. Bei dem anschließenden Trench-Prozess für die Strukturierung der polykristallinen Siliziumschicht 4 würden sich die Partikel in den Öffnungen 6 auf die Schicht 4 übertragen. Durch nachfolgende Prozessschritte können sich frei bewegliche Partikel bilden, die die Funktion eines mikromechanischen Bauteils beeinträchtigen. Dies kann durch eine temporäre Germanium-Schutzschicht 7, die bei diesem Ausführungsbeispiel selektiv aufgewachsen wird, verhindert werden.

Die Germanium-Schutzschicht 7 wird selektiv in den Öffnungen 6 der Hartmaske aus der dritten Oxidschicht 5 aufgewachsen, wie in Fig. 2 gezeigt. Das Aufwachsen erfolgt in einer Niedertemperatur(<450°C)-LPCVD-Anlage. Durch das Auffüllen der Öffnungen 6 mit Germanium können sich in diesen Öffnungen keine Partikel anlagern. Partikel auf der Oxidmaske 5 bzw. auf der Germanium-Schutzschicht 7 haben keine Auswirkungen auf den Trench-Prozess. Insbesondere werden Partikel, die sich während des Rückseitenprozesses auf der Germanium-Schutzschicht 7 anlagern, bei dem späteren naßchemischen Entfernen dieser Schicht 7 ebenfalls entfernt.

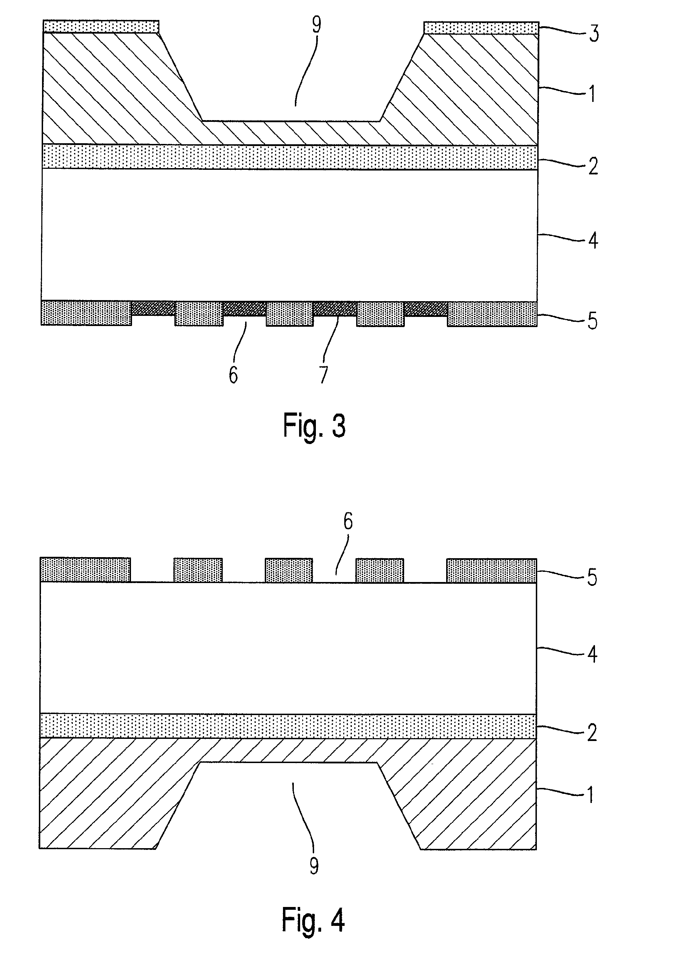

Nach dem Aufbringen der Germanium-Schutzschicht 7 wird der Wafer für die Rückseitenprozessierung gedreht, wie in Fig. 3 gezeigt. Auf die Waferrückseite wird eine Nitridschicht 8 aufgebracht. Die Nitridschicht 8 und die darunterliegende zweite Oxidschicht 3 werden anschließend strukturiert. Die Schichten 3, 8 dienen dann als Ätzmaske für einen nachfolgenden KOH-Ätzprozess, bei dem z. B. eine Kaverne 9 in das Substrat 1 vor der Rückseite her geätzt wird. Nach dem KOH-Ätzprozess werden die Schichten 3, 8 entfernt, und der Wafer wird für die Vorderseitenprozesse wieder gedreht.

Wie in Fig. 4 gezeigt ist, wird anschließend die Germanium-Schutzschicht 7 in den Öffnungen 6 naßchemisch mittels einem Wasserstoffperoxid (H₂O₂) enthaltenden Medium entfernt.

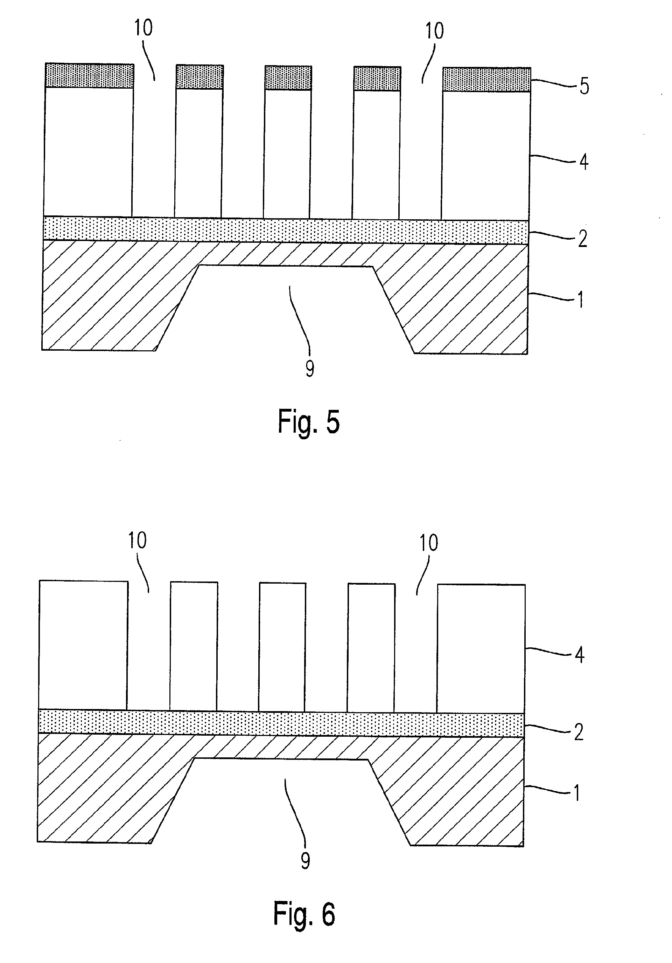

Danach erfolgt die Strukturierung der Siliziumschicht 4, wie in Fig. 5 illustriert. Dabei werden Gräben 10 mittels des bekannten Trench-Prozesses eingebracht. Würden bei der naßchemischen Ätzung der Germanium-Schutzschicht 7 Partikel oder Reste in den Öffnungen 6 zurückbleiben, so würden diese keine Auswirkung auf die Strukturierung der Siliziumschicht 4 haben, da Germanium mit dem gleichen Ätzprozess wie Silizium geätzt wird.

Abschließend wird noch die Hartmaske aus der dritten Oxidschicht 5 entfernt. Fig. 6 zeigt den Wafer, nachdem der Vorder-/Rückseitenprozess abgeschlossen ist.

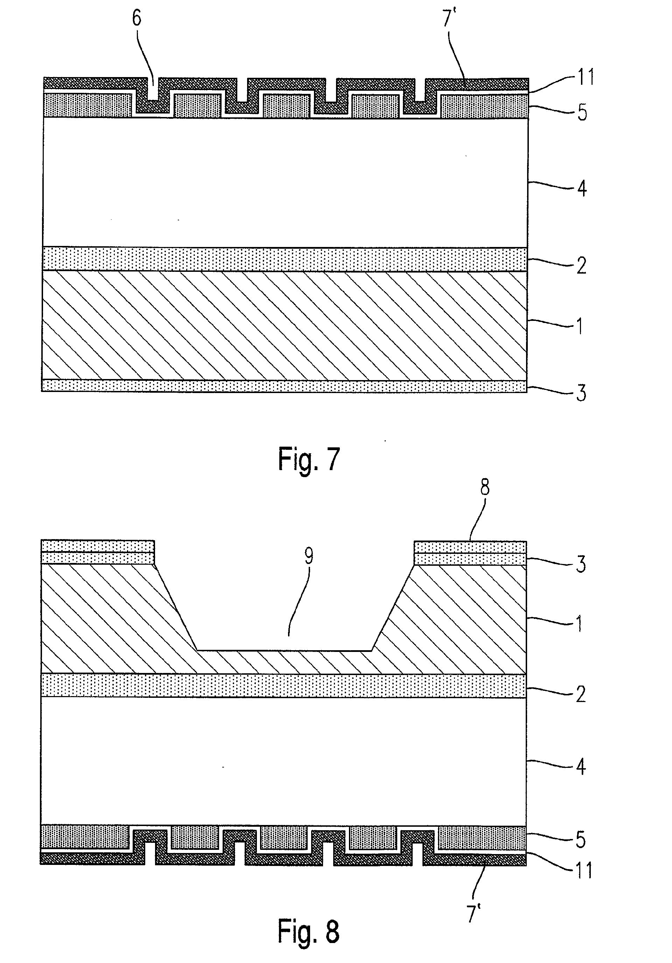

Fig. 7-11 zeigen eine schematische Querschnittsdarstellung des Herstellungsprozesses für einen Drehratensensor gemäß einer zweiten Ausführungsform der vorliegenden Erfindung.

Bei dieser zweiten Ausführungsform wird die Germanium-Schutzschicht 7' mit Hilfe einer dünnen polykristallinen Silizium-Nukleationsschicht 11 ganzflächig auf der Wafervorderseite aufgewachsen, wie in Fig. 7 illustriert.

Durch die ganzflächige Germanium-Schutzschicht 7' ist die strukturierte dritte Oxidschicht 5 vollständig geschützt. Beim Rückseitenprozess kann daher die Oxidmaske aus der dritten Oxidschicht 5 nicht beschädigt werden, und Partikel können sich nur noch an der Oberfläche der Germaniumschicht 7' anlagern.

Das Abscheiden der Polysilizium-Nukleationsschicht 11 erfolgt gleichzeitig auf der Vorder- und Rückseite des Wafers. Die Nukleationsschicht 11 wird anschließend auf der Waferrückseite entfernt.

Nach dem Aufbringen der Germanium-Schutzschicht 7' wird der Wafer für die Rückseitenprozessierung gedreht, wie in Fig. 8 gezeigt.

Auf die Waferrückseite wird wie beim ersten Ausführungsbeispiel eine Nitridschicht 8 aufgebracht. Die Nitridschicht 8 und die darunterliegende dritte Oxidschicht 3 werden anschließend strukturiert. Die Schichten 3, 8 dienen als Ätzmaske für den nachfolgenden KOH-Ätzprozess, bei dem z. B. eine Kaverne 9 in das Substrat 1 geätzt wird.

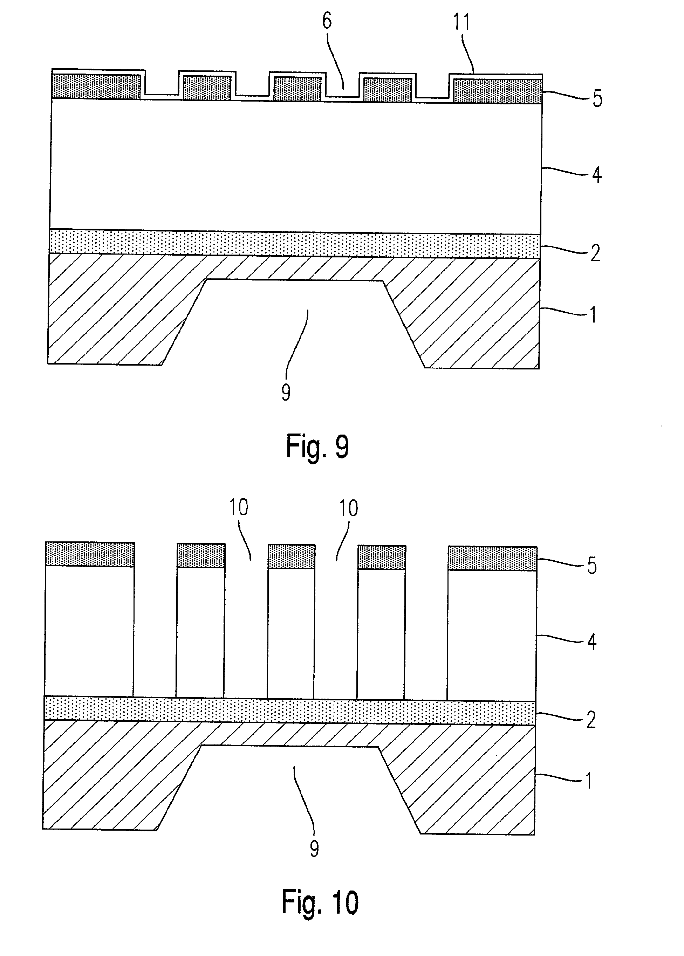

Nach dem Ätzprozess werden die Schichten 3, 8 entfernt und der Wafer wird für die Vorderseitenprozesse gedreht. Wie in Fig. 9 gezeigt ist, wird anschließend die Germanium-Schutzschicht 7' naßchemisch mittels Wasserstoffperoxid (H₂O₂) enthaltenden Medium entfernt. Dabei bleibt die Polysilizium-Nukleationsschicht 11 erhalten. Diese Schicht 11 wird bei der anschließenden Strukturierung der Siliziumschicht 4, bei der die Gräben 10 mittels des Trench-Prozesses eingebracht werden, entfernt, wie in Fig. 10 erkennbar.

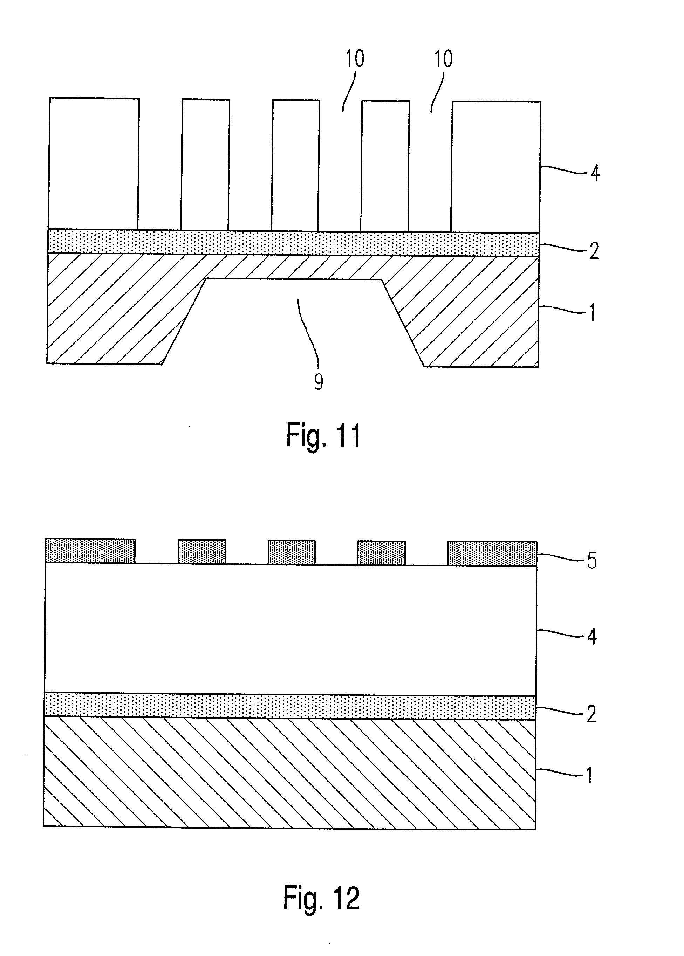

Abschließend wird noch die Hartmaske aus der dritten Oxidschicht 5 entfernt. Fig. 11 zeigt den Wafer nach dem der Vorder-/Rückseitenprozess abgeschlossen ist.

Fig. 12-15 zeigen eine schematische Querschnittsdarstellung des Herstellungsprozesses für einen Drehratensensor gemäß einer dritten Ausführungsform der vorliegenden Erfindung.

Beim rückseitigen KOH-Ätzprozess kann Germanium als Ätzmaske eingesetzt werden, da es von KOH nicht angegriffen wird. Es wird von einem Schichtaufbau, wie er in Fig. 12 dargestellt ist, ausgegangen. Dabei befindet sich auf der Waferrückseite keine zweite Oxidschicht 3.

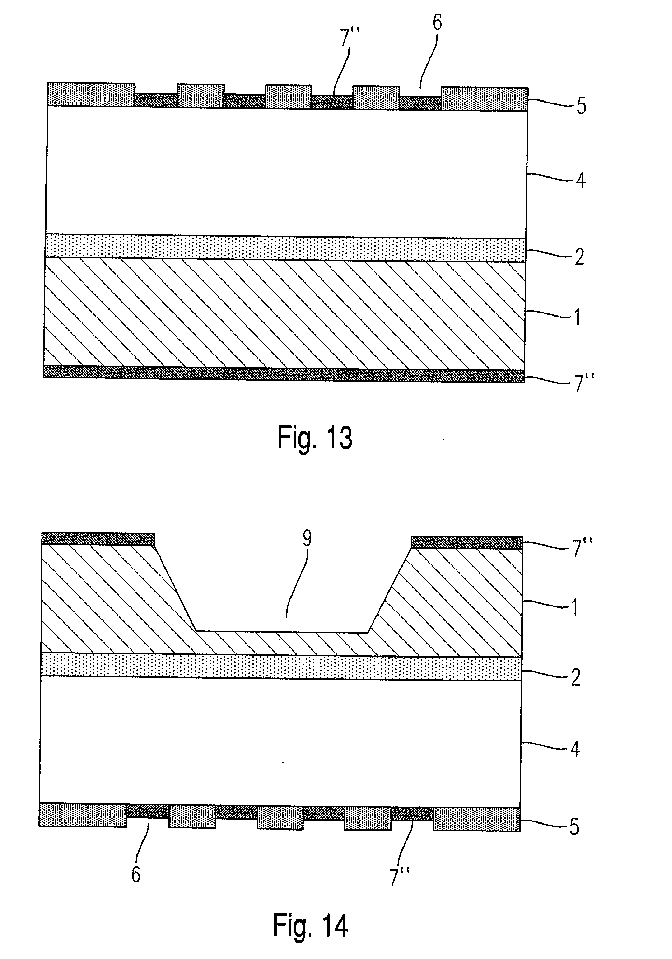

Da Germanium überall dort aufwächst wo Silizium vorhanden ist, erhält man auf der Vorder- und Rückseite eine Germanium-Schutzschicht 7'', wie in Fig. 13 dargestellt.

Nach dem Aufbringen der Germanium-Schutzschicht 7'' wird der Wafer für die Rückseitenprozessierung gedreht. Die Germanium-Schutzschicht 7'' auf der Waferrückseite wird dann über einen Fotoprozess und einen Trockenätzprozess strukturiert. Die strukturierte Germanium-Schutzschicht 7'' auf der Rückseite dient dann als Ätzmaske bei dem anschließenden KOH-Ätzprozess, wie Fig. 14 entnehmbar.

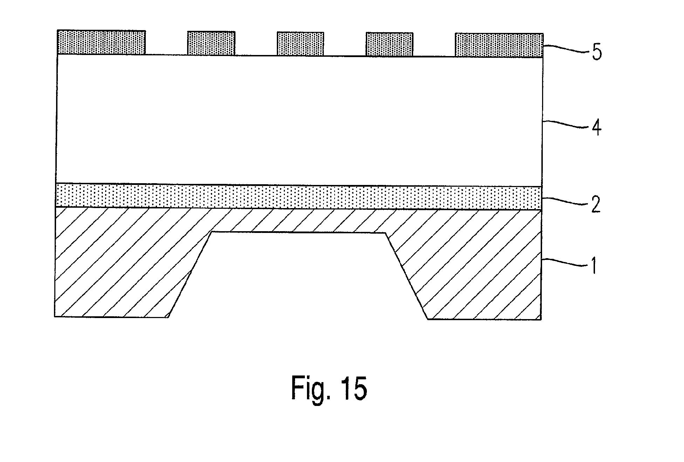

Die Germaniumschichten 7'' auf der Vorder- und Rückseite werden anschließend naßchemisch mittels einem Wasserstoffperoxid enthaltenden Medium entfernt, wie in Fig. 15 gezeigt. Die weitere Strukturierung erfolgt dann wie oben mit Bezug auf die erste bzw. zweite Ausführungsform erläutert.

Obwohl die vorliegende Erfindung vorstehend anhand bevorzugter Ausführungsbeispiele beschrieben wurde, ist sie darauf nicht beschränkt, sondern auf vielfältige Weise modifizierbar.

Insbesondere ist die spezielle Auswahl der Grundmaterialien und Schichtmaterialien nur beispielhaft gewählt.

## Patentansprüche

1. Verfahren zum Herstellen eines mikromechanischen Bauelements mit den Schritten:
Bereitstellen eines Substrats (1; 2; 4) mit einer Vorderseite und einer Rückseite;
Strukturieren der Vorderseite des Substrats (1; 2; 4);
zumindest teilweises Abdecken der strukturierten Vorderseite des Substrats (1; 2; 4) mit einer Germanium-enthaltenden Schutzschicht (7; 7'; 7'');
Strukturieren der Rückseite des Substrats (1; 2; 4); und
zumindest teilweises Entfernen der Germanium-enthaltenden Schutzschicht (7; 7'; 7'') von der strukturierten Vorderseite des Substrats (1; 2; 4).

2. Verfahren nach Anspruch 1, **dadurch gekennzeichnet, daß** das Substrat (1; 2; 4) ein Wafersubstrat (1), eine darauf vorgesehene erste Opferschicht (2) und eine darauf vorgesehene mikromechanische Funktionsschicht (4) aufweist, wobei die mikromechanische Funktionsschicht (4) die Vorderseite und das Wafersubstrat (1) die Rückseite bildet.

3. Verfahren nach Anspruch 1 oder 2, **dadurch gekennzeichnet, daß** auf der Vorderseite des Substrats (1; 2; 4) eine erste Hartmaske (5; 6) gebildet wird und die Germanium-enthaltende Schutzschicht (7; 7'') selektiv in den Öffnungen (6) der Hartmaske (5; 6) gebildet wird.

4. Verfahren nach Anspruch 3, **dadurch gekennzeichnet, daß** auf der Rückseite des Substrats (1; 2; 4) die Germanium-enthaltende Schutzschicht (7; 7'') ganzflächig gebildet wird.

5. Verfahren nach Anspruch 1 oder 2, **dadurch gekennzeichnet, daß** auf der Vorderseite des Substrats (1; 2; 4) eine erste Hartmaske (5; 6) gebildet wird und die Germanium-enthaltende Schutzschicht (7') ganzflächig über der Hartmaske (5; 6) gebildet wird.

6. Verfahren nach Anspruch 5, **dadurch gekennzeichnet, daß** die Germanium-enthaltende Schutzschicht (7') über einer ganzflächigen Nuleationsschicht (11) gebildet wird.

7. Verfahren nach einem der vorhergehenden Ansprüche, **dadurch gekennzeichnet, daß** auf der Rückseite des Substrats (1; 2; 4) eine zweite Hartmaske (3, 8; 7'') gebildet wird und damit bei zumindest teilweise durch die Germaniumenthaltende Schutzschicht (7; 7'; 7") abgedeckter Vorderseite eine Kaverne (9) in die Rückseite geätzt wird.

8. Verfahren nach Anspruch 7, **dadurch gekennzeichnet, daß** nach dem Ätzen der Kaverne (9) die Germanium-enthaltende Schutzschicht (7; 7'; 7'') von der Vorderseite entfernt wird und dann mittels der ersten Hartmaske (5; 6) Gräben (10) in der mikromechanischen Funktionsschicht (4) geätzt werden.

9. Verfahren nach Anspruch 7 oder 8, **dadurch gekennzeichnet, daß** die zweite Hartmaske (3, 8; 7'') aus der rückseitigen enthaltenden Schutzschicht (7'') gebildet wird.
